# EUROPEAN PATENT SPECIFICATION

(11) **EP 0 410 067 B1**
(45) Date of publication and mention of the grant of the patent: **22.09.1993**
(21) Application number: 89810577.0
(22) Date of filing: 27.07.1989
(51) Int. Cl.: H01L 33/00, H01S 3/025

(54) **Integrated semiconductor diode laser and photodiode structure**
Integrierte Halbleiterdiodenlaser und Photodiodenstruktur
Structure intégrée semi-conductrice diode laser-photodiode

(43) Date of publication of application: 30.01.1991
(73) Proprietor: International Business Machines Corporation, Armonk, N.Y. 10504 (US)
(72) Inventor: Buchmann, Peter Leo, Dr., CH-8135 Langnau am Albis (CH); Harder, Christoph Stephan, Dr., CH-8038 Zurich (CH); Voegeli, Otto, Dr., CH-8803 Rüschlikon (CH)
(74) Representative: Barth, Carl Otto

(56) References cited:
- US-A- 4 698 129
- ELECTRONICS LETTERS, vol. 23, no. 16, 30th July 1987, pages 855-857, Stevenage, Herts, GB; N. BOUADMA et al.: "GaAs/AlGaAs ridge waveguide laser monolithically integrated with a photodetector using ion beam etching"
- ELECTRONICS LETTERS, vol. 22, no. 11, May 1986, pages 585-587, Stevenage, Herts, GB; M. UCHIDA et al.: "Integrated AlGaAs two-beam LD-PD array fabricated by reactive ion beam etching"
- IEEE JOURNAL OF QUANTUM ELECTRONIS, vol. QE-23, no. 2, February 1987, pages 160-163, New York, US; H. NOBUHARA et al.: "One-chip optical transmitter with a microcleaved facet AlGaAs/GaAs GRIN-SCH SQW laser"

## Description

### Technical Field

The invention concerns a semiconductor structure with integrated laser diode and photodiode, the latter being provided for both, testing in full-wafer prosessing fabrication and for laser beam monitoring. The photodiode structure is designed for measuring the far-field intensity distribution of the light beam of the associated diode laser and allows on-wafer screening of lasers with respect to their modal stability.

### Background of the Invention

Semiconductor laser diodes have found applications in a wide variety of information handling systems because of their compact size and because their technology is compatible with that of the associated electronic circuitry. They are being used in areas such as data communications, optical storage and optical beam printing.

Aiming at improved device performance and fabrication cost reduction, there is a strong trend towards integration of opto-electronic devices. Among other examples, diode lasers and monitor photodiodes have been integrated, the photodiode, normally facing the rear-end facet of the laser diode, being commonly used for monitoring and stabilizing the laser output power.

Such integrated laser diode/photodiode structures have been described in a number of publications for which the following are representative :
- Article "GaAS/AlGaAs Ridge Waveguide Laser monolithically integrated with a Photodetector using Ion Beam Etching", by N.Bouadma et al (Electronics Letters 30th July 1987, Vol.23, No.16, pp 855-857), describes a laser diode which is integrated with a monitoring photodiode. The laser diode and the photodiode have, respectively, vertical and slanted etched facets fabricated with an ion beam etching process. The slanted photodiode facet reduces parasitic light reinjection but has no effect on the uniform sensitivity profile of the photodiode.
- Article "Integrated AlGaAs Two-Beam LD-PD Array fabricated by Reactive Ion Beam Etching", by M.Uchida et al (Electronics Letters 22nd May 1986, Vol.22, No.11, pp 585-587), discloses a monolithically integrated laser diode/photodiode array which provides a light source having parallel multiple beams, controllable by photodiodes associated with the individual laser diodes. The laser diodes and the photodiodes have vertical facets, parallel to each other, and are formed by reactive ion etching of a groove of about 20 um width. High coupling efficiency is achieved.
- Article "Monolithic Integration of Laser Diodes, Photomonitors, and Laser Driving and Monitoring Circuits on a semi-insulating GaAs", by H.Nakano et al (IEEE Journal of Lightwave Technology, Vol.LT-4, No.6, June 1986, pp 574-582), is a report on the authors' work on an opto-electronic integrated circuit (OEIC) comprising electro-optical devices and associated electronic circuitry. The laser diode and the photodiode are of the same structure, the photodiode being operated under reverse-bias condition. The gap between the two devices was obtained using an etching process resulting in vertical, parallel facets. In the described set-up, a second laser diode and photodiode were integrated to check the current - light output characteristics of single devices.
- Article "AlGaAs OEIC Transmitters", by H.Matsueda (IEEE Journal of Lightwave Technology, Vol. LT-5, No.10, October 1987, pp 1382-1390). This paper discusses the state of the art of opto-electronic circuits. It shows a horizontal integrated structure with a laser diode and a photo monitor for automatic power control. Both devices have the same cross-section and are separated by a narrow etched groove. As in the two previous references, the facets are vertical and parallel to each other.

In these known integrated structures, the photodiodes are only capable of providing a measured signal, i.e., the photodiode current, that is proportional to the total beam power of the associated laser diode. The signals do not contain information on the spatial distribution of the beam intensity.

A measurement of the spatial distribution is, however, of great importance for new fabrication processes currently attracting attention. In these processes, the laser mirrors of all devices on a wafer are obtained by etching trenches the walls of which serve as mirror facets. This full-wafer processing yields functional parts at the wafer level and will greatly reduce part handling if the lasers can also be tested and screened "on-wafer". This approach is, furthermore, well suited for fabricating, together with the laser diodes, structures which facilitate testing and monitoring, e.g., photodiodes.

An important laser criterion to be tested is the modal stability which affects the noise level (critical in communication system applications) and the beam divergence (critical in power applications). The usual requirement is that there be only the fundamental mode and that it be stable over the range of operating and drive conditions. Undesired modal changes result in changes in the intensity distribution in the "far-field" of the laser beam. Therefore, a test structure that is capable of detecting such changes and that can be integrated and fabricated together with the laser to be tested is in demand since it will permit on-wafer screening of the laser diodes.

It is thus a main object of the present invention to provide a test structure that allows on-wafer screening of laser diodes against a set of criteria, in particular those related to modal stability, and that can be incorporated at virtually no extra expenditure in processing cost or wafer area.

Another main object is to provide a photodiode, integrated with an associated laser diode, having a spatially non-uniform light sensibility profile resulting in a photocurrent that varies with varying intensity distribution of the light beam impinging on the photodiode.

A further object is to provide a method of screening a plurality of laser diodes formed on a wafer that allows the detection of modal instabilities of the laser beams.

### Summary of the Invention

The invention as claimed is intended to meet these objectives and to remedy the deficiencies of known integrated photodiode structures. In the inventive structure this is accomplished by a photodiode, optically coupled with the associated laser diode to be tested, that has a spatially non-uniform sensitivity profile with regard to the incident laser light beam. With this, the resulting photocurrent varies with varying intensity distribution of the beam.

In the specific embodiments of the invention which will be described hereinafter, the spatially non-uniform sensitivity profiles are obtained either by a particular shape of the vertical photodiode facet or by its position with regard to direction of propagation of the light beam emitted from the laser. In a first case, the diode surface is non-linear whereby the distance from the laser light mode region varies. In a second embodiment, the straight vertical diode facet is tilted with regard to the optical axis of the light beam by the so-called Brewster angle.

The advantages offered by the invention are mainly that the structure allows the detection of variations in beam intensity distribution and thus of transverse mode transitions. It permits, and this is of particular importance, on-wafer assessment of the far-field behavior and thus comprehensive on-wafer screening of laser diodes. The new diode design further avoids back-reflection of the laser beam into the laser.

### Description of the Drawings

Various ways of implementing the invention are described in detail below with reference to drawings which illustrate specific embodiments and in which
- **Fig. 1A**: is a perspective view of a state of the art integrated laser diode/monitor diode structure (PRIOR ART).
- **Fig. 1B**: is a schematic top view of the structure of Fig.1A (used for illustrating the operational concept).
- **Fig. 2A**: is a perspective view of a first embodiment of an integrated laser diode/photodiode structure designed in accordance with the present invention.
- **Fig. 2B**: is a schematic top view of the structure of Fig.2A (used for illustrating the inventive concept).
- **Fig. 3**: is an l_{diff}/l_{LD} diagram obtained from measurements of various structures corresponding to that of Fig.2A, the curves representing the far-field intensity distribution of different diode lasers.
- **Fig. 4**: is a schematic top view of a layout of an array of integrated laser diode/photodiode structures on a wafer, the structures corresponding, in principle, to those shown in Fig.2A.
- **Fig.5A**: is a perspective view of a second embodiment of an integrated laser diode/photodiode structure designed in accordance with the present invention.
- **Fig. 5B**: is a schematic top view of the structure of Fig.5A (used for illustrating the inventive concept).
- **Fig. 6**: is a diagram showing the reflection (R) and transmission (T) of an air/GaAs interface versus the angle of incidence of impinging polarized laser light; it also illustrates the intensity distribution of the fundamental and the first order mode of a laser beam.
- **Fig. 7**: shows l_{PD}/l_{LD} diagrams obtained from (A) a state-of-the-art laser diode/photodiode structure (as in Fig.1A), and from (B) the inventive structure of Fig.5A. Diagram (B) illustrates the distinct kink appearing when a mode change occurs.

### Detailed Description

Before describing the embodiments of the inventive device in greater detail, the underlying general concept will be outlined by comparing a known integrated laser diode/monitor diode structure with that of the invention, both in AlGaAs/GaAs technology and both using etched facet devices. Such known structures are described in, e.g., the above referenced articles by M.Uchida et al, H.Nakano et al, and H.Matsueda.

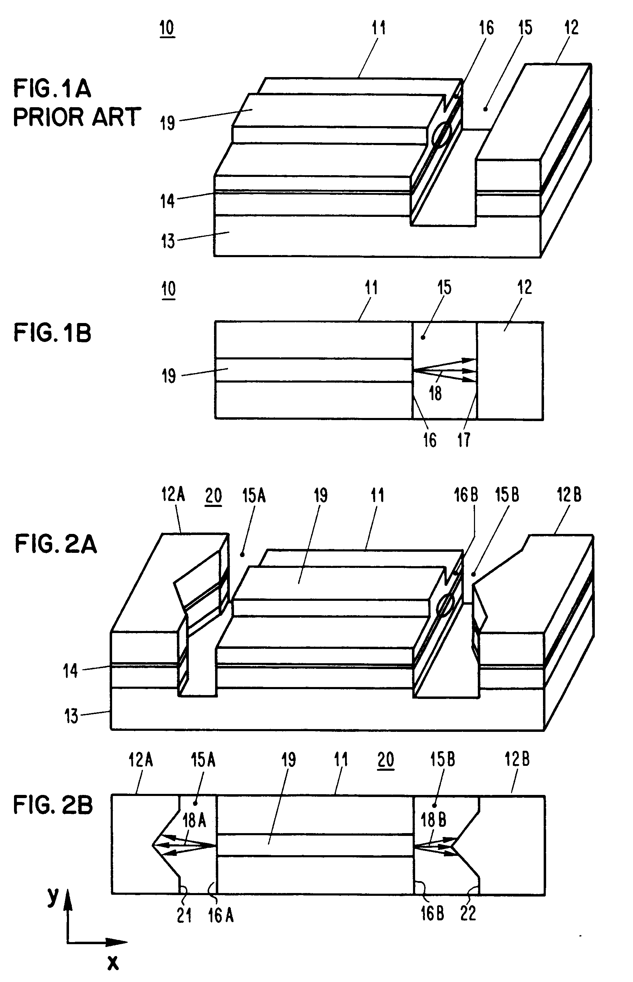

Fig.1A is a perspective view of such a known laser diode/photodiode structure 10. Only the main elements are shown. Fig.1B is a further simplified, schematic top view of the same structure.

The main elements of the structure 10 are the laser diode 11 and the photodiode 12. Both are formed in a stack of layers that are epitaxially grown on a GaAs substrate 13, the stack including at least the active layer which is sandwiched between cladding layers. For clarity reasons, only the active layer 14 is indicated in Fig.1A. The drawings show the structure after completion of the etch process forming the groove 15 that provides the laser mirror facet 16 and the photodiode facet 17. Omitted in the drawings are the metallization layers providing for the electrical contacts to the completed device.

In Fig.1A, the light mode region of the laser is shown as a small ellipse, centering around the active layer 14 and laterally defined by the stripe ridge 19. The bundle of arrows 18 in Fig.1B represent the light beam emitted from the laser that impinges onto the photodiode facet 17.

When the device is activated by applying proper operating voltages, the resulting photocurrent is representative of the total beam power and, because of the spatially uniform sensitivity, is not affected by any change in light beam intensity distribution. The photodiode 12 is used to monitor the operation of the laser 11 and serves to sense and signal any variations in beam power during the lifetime of the laser. Normally, the (weaker) beam emitted at the rear-end of the laser is used for monitoring; the main beam leaving the laser at the opposite front-end.

Figures 2A & B are illustrations of a first embodiment of an integrated diode laser/photodiode structure 20 designed in accordance with the present invention. The structure comprises a pair of photodiodes 12A and 12B, arranged, respectively, opposite the front-end and the rear-end of the laser. Both have a spatially non-uniform sensitivity profile.

Basically, the structure of both, the laser and the photodiodes are the same as that of the device shown in Fig.1A. Consequently, the same reference numbers have been used for same elements. For the two photodiode structures, number pairs such as 12A and 12B, 15A and 15B, etc., have been chosen for corresponding elements. It is to be noted that both beams, the front-end beam 18A and the rear-end beam 18B, are used in testing the laser diode.

The structure 20 in Fig.2A is distinguished over the known devices (illustrated in Fig.1A) mainly in that the photodiode facets 21 and 22 are shaped, they are not linear or plane. The profiles of the two facets are mutually inverse. In the illustrated embodiment, facet 21 is concave whereas facet 22 has a convex shape.

The principle of the operation of the structure 20 will now be described. The laser beam, with a divergence D, impinges onto a photodiode, arranged at a distance $\text{x = s(y)}$ and having a sensitive region of a height h. At the photodiode facet, the fraction η(y) of collected light varies along the horizontal direction y with s(y) as

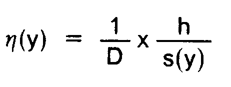

A laser beam with a horizontal intensity profile p(y) thus induces a diode photocurrent

$\text{i(y) ∼ η(y) x p(y)}$

With a plane photodiode facet, where x = s₀, and assuming a small beam divergence D (almost perpendicular incidence), η is virtually constant and the output signal is

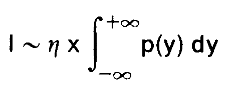

This means that the resulting photodiode current is just a function of total beam power and independent of the intensity distribution. This is what can be measured with the known prior art devices.

With the shaped facets of the present invention, the collection efficiency varies along y, in tune with the distance s(y), and the output current becomes

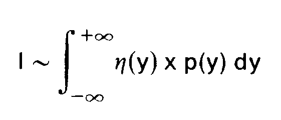

This shows that the output signal depends on the shape of the horizontal intensity profile of the photodiode. Either geometry, that of facet 21 as well as that of facet 22, can serve as spatially non-uniform sensitivity sensor, photodiode 12A being least sensitive in the center, photodiode 12B being most sensitive in the center.

Using only one of the photodiodes, i.e., either 12A or 12B, the problem remains that the output current is still proportional to the beam power and only to a smaller extent dependent on beam shape or beam intensity distribution. This is not satisfactory since changes in intensity distribution need to be tested versus beam power (or laser current) variations. In other words, the measured, far-field dependent signal should be insensitive to the total beam power.

This is accomplished by employing the inverse pair of sensors, 12A and 12B, one facing the front-end and one facing the rear-end of the laser. If these sensors are used differentially, the differential output signal ${\text{l}}_{\text{diff}} {\text{= l}}_{\text{12a}} {\text{- l}}_{\text{12B}}$ has the desired attribute: it is insensitive to the total beam power.

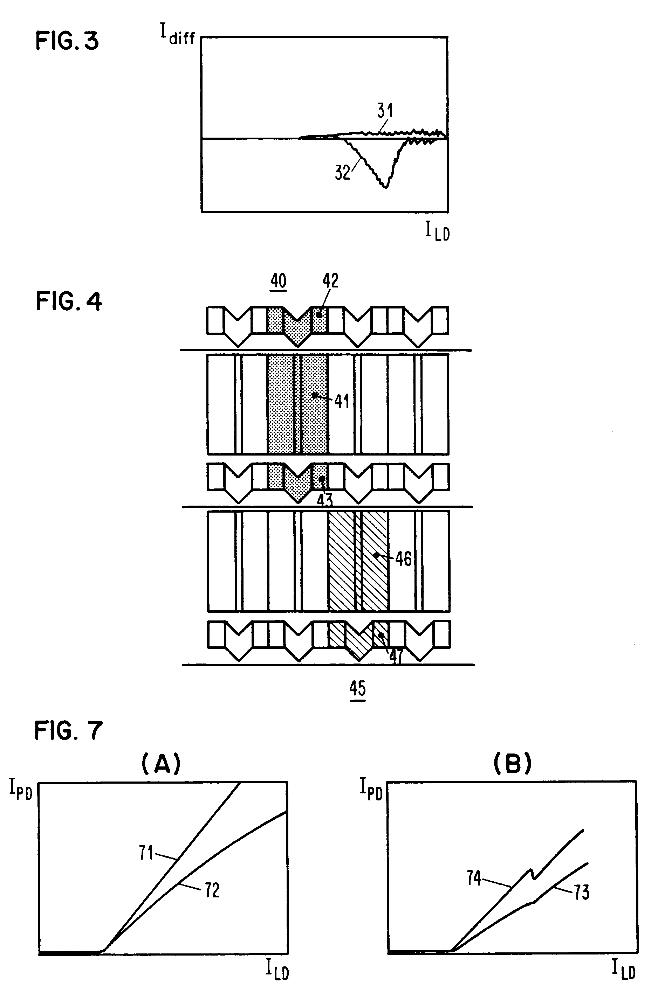

Fig.3 is a measured diagram in which the differential signal l_{diff} is recorded versus the laser current l_{LD}. Gain adjustment has been made to adjust for the difference in beam power between front- and rear-end beam. Curve 31 is representative of a laser where the beam intensity distribution does not vary substantially with increased laser current l_{LD}. Curve 32, on the other hand, clearly indicates a gradual change in the intensity distribution.

With these spatially non-uniform sensitivity-profile photodiodes, changes in laser mode configuration can be detected since modal changes cause changes in the light intensity distribution. This means that lasers can be efficiently tested with regard to the very important criterion of modal stability. The usual requirement being that there be only the fundamental mode and that it be stable over the range of drive conditions occuring during device operation.

Since arrays of the inventive integrated laser diode/photodiode device can be fabricated and tested "on wafer", the new structure allows comprehensive full-wafer screening of laser diodes without requiring additional expenditure, neither in processing nor in wafer area, if the photodiode is subsequently used as a monitor diode.

The fabrication process for the integrated laser diode/photodiode structure of Fig.2A will now be outlined.

The epitaxially grown multi-layer structure which forms the basis for the laser 11 and the two photodiodes 12A and 12B, can be structurally the same and fabricated using the same process as that described in an article by C.Harder et al, entitled "High-Power Ridge-Waveguide AlGaAs GRlNSCH Laser Diode" and published in Electronics Letters 25th September 1986, Vol.22, No.20, pp 1081-1082. The sequence of steps for producing the stack of layers (not all of them are specifically indicated in Fig.2A) is as follows:

The layers are grown on an n+ -doped GaAs substrate 13 by, e.g., molecular beam epitaxy (MBE). First, an n-doped GaAs buffer layer is grown on the substrate. Next is a lower, n-type cladding layer (Al_{0.45}Ga_{0.55}As). The core of the laser consists of a graded n-type region (0.2 µm Al_{0.45}Ga_{0.55}As graded towards Al_{0.18} Ga_{0.82} As), an undoped active region 14 forming a quantum well (7 nm GaAs), and a graded p-type region (0.2 µm Al_{0.18}Ga_{0.82}As graded towards Al_{0.45} Ga_{0.55}As). Next is the top p-type cladding layer (Al_{0.45}Ga_{0.55}As), followed by a p+ -GaAs contact layer with a doping density that is high enough for a titanium-platinum-gold electrode to make good ohmic contact. Another ohmic contact, at the bottom side of the n-type substrate 13, is obtained by alloying germanium, gold and nickel.

When needed for lateral waveguiding, a ridge 19, about 4 µm wide, can be formed on top of the structure (as shown in Fig.2a) prior to applying the metal contact electrodes. This is done by first applying a photoresist mask to define the ridge. Subsequently, 1 to 2 µm of the exposed top layers are etched, etching being stopped 0.2 µm above the graded-index part of the top cladding layer. This is followed by depositing 100 nm SiO₂ and subsequent lift-off, removing the SiO2 on the ridge.

Mirror grooves 15A and 15B are then etched using a mask and an etching method that can correspond to those described in detail in pending European patent application 88.810613.5, filed on September 12, 88. In brief, this method involves, first, the deposition of a three-layer etch mask onto the layered structure just described. The mask consists of two photoresist layers, a hard-baked bottom layer and a soft-baked top layer, with an amorphous dielectric intermediate layer sandwiched inbetween. The etch pattern, lithographically formed in the top resist layer for the definition of grooves 15A and 15B, is successively transferred : first into the intermediate layer and then into the bottom layer. Prior to etching the mirror groove into the layered structure, the intermediate layer is removed to prevent its erosion. A chemically assisted ion beam etch process (CAIBE) is used to etch the groove, the patterned hard-baked resist layer serving as mask.

Typical dimensions of the structure shown in Fig.2A are : The length of the laser 11 is between 600 and 800 µm, that of the photodiodes about 100 µm; the width of both is in the order of 100 to 200 µm. For the measured device, the distance between the laser facet and the closest point on the shaped photodiode facet was chosen to be 6 µm. The "depth" of the recess (facet 21) and the "height" of the projection (facet 22) was 5 µm. Other shapes, e.g., rounded rather than edged, can of course also be used.

Since the photodiodes are fabricated along with the lasers, there is no added processing cost. There also need not be any overhead in wafer area if a configuration is designed where the photodiodes can serve, first, for part-screening during on-wafer testing,and subsequently as integrated monitor diode during laser use in one of the potential applications. This is accomplished with the integrated structure illustrated in Fig.2A with a proper layout on the wafer.

Fig.4 shows a schematic top view of such a layout of an array of structures essentially corresponding to the structure 20 of Fig.2A. The only difference being that photodiodes 12A and 12B of neighbouring structures are combined, back-to-back, into single elements such as those designated 43 and 47 in Fig.4. For screening of, e.g., laser 41, shaded structure 40 is used that consists of laser 41 and the two back-to-back, double-function photodiodes 42 and 43, providing the needed differential pair. Each photodiode serves, successively, two rows of lasers: once as front-end sensor for one row and once as rear-end sensor for the next row.

When the laser is in use, a single photodiode is sufficient for monitoring. The laser/photodiode combination then used consists of the laser 46 and the photodiode 47. This combination, designated 45, is shown hatched in Fig.4. It is obtained by parting the devices on the wafer along the cleaving lines "C".

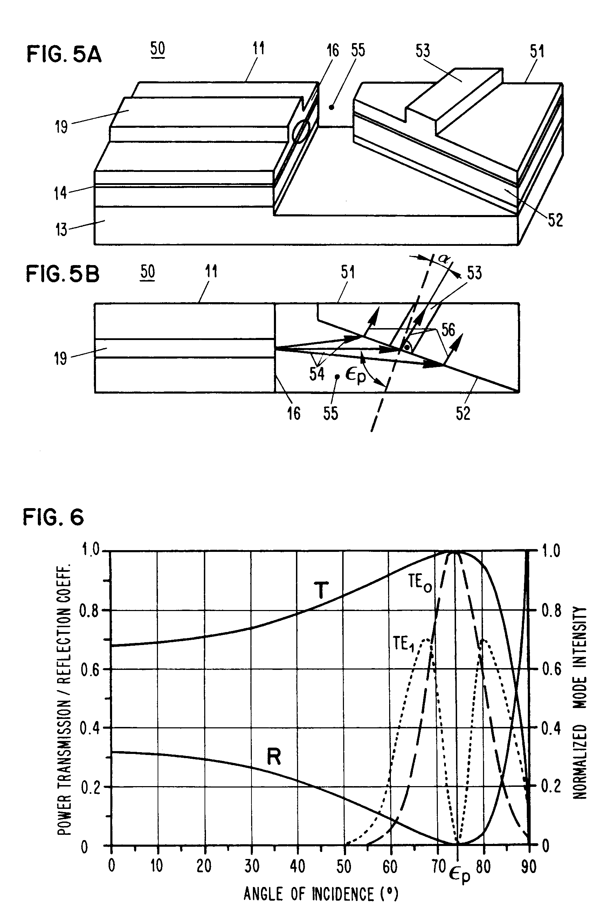

Figures 5A and 5B are illustrations of a second embodiment of an integrated laser diode/photodiode structure designed in accordance with the present invention. The structure 50 comprises a diode laser 11 and a photodiode 51, the latter having a spatially non-uniform sensitivity profile.

Basically, the structure of both, the laser diode 11 and the photodiode 51, are the same as that of the devices shown in Fig.1A and Fig.2A. Again, the same reference numbers have been used for corresponding elements.

The structure 50 is distinguished from the known devices mainly in that the facet 52 of the photodiode 51 is tilted with respect to the propagation direction of the laser beam 54. The tilt angle εp is equal to the so-called Brewster angle at which the incident transverse mode(TM)-polarized (with respect to the tilted photodiode facet) light beam is not reflected but totally transmitted into the photodiode material as indicated by the arrows 56, i.e., the reflection coefficient is zero.

This is illustrated in the diagram of Fig.6, showing the reflection R and the transmission T of an air/GaAs interface versus the angle of incidence of the TM-polarized laser light. For GaAs and a wavelength of λ = 0.84 µm, the Brewster angle εp is 74.4 °. The angle can be determined using the handbook "Optical Data Processing", by A.R.Shulman (John Wiley & Sons, Inc., 1970, pp 92 - 94).

From the diagram shown in Fig.6 it is apparent that the maximum transmission occurs at the exact Brewster angle εp. Any diverging or broadening of the laser beam, as is the case for a laser beam as indicated by the bundle of arrows 54 in Fig.5B, results in light that is incident at angles different from the Brewster angle. Transmission of this light through the tilted photodiode facet into the photodiode structure is reduced, resulting in a spatially non-uniform sensitivity distribution of the photodiode. In other words, structure 50 allows the detection of changes in the beam intensity distribution. As with the structure 20 of the embodiment of Fig.2A, this non-uniform photodiode characteristic can thus be used to detect any switching from the single transverse mode to a higher order mode. Structure 50 allows on-wafer testing.

The diagram of Fig.6 also shows the intensity distribution curves TE₀ and TE₁, normalized with respect to the total output power, for the fundamental mode and for the first order mode, respectively. From curve TE₀ it can be seen that the fundamental mode is transmitted through the tilted photodiode facet almost completely. The first order mode, curve TE₁, has a minimum in the intensity distribution at the tilting angle. If this angle is near the Brewster angle, the overall transmission of light through the photodiode facet is significantly larger for the fundamental mode than for the first order mode. Since the measured photocurrent is proportional to the light power coupled into the photodiode waveguide, a distinct kink or step in the diode photocurrent results whenever a transverse mode transition occurs. This has been confirmed by measuring the photocurrents l_{PD} of a Brewster-angle tilted-facet photodiode (Fig.5A) and a parallel facet photodiode (Fig,1A) that were integrated at the ends of a single mode ridge laser, as a function of the laser drive current l_{LD} . Fig.7A shows the typical behavior of devices were no mode change occurs: an essentially linear increase of the photocurrent in the parallel-facet photodiode (curve 71), and a sublinear characteristic 72 of the Brewster-angle facet photodiode. The behavior of curve 72 corresponds to the beam broadening seen in the far-field of laser beams with increasing power. Fig.7B represents the measurement of a laser where a mode-jump occurs. As expected, the signal 74 from the Brewster-angle tilted-facet photodiode has a distinct step whereas the signal 73 from the parallel-facet photodiode only shows a hardly recognizable small kink.

It is noted that the curves 72 and 74 reflect measurements of a structure where the photodiode 51 is provided with a ridge waveguide 53 (shown in Fig.5A & B) running parallel to the light transmitted into the photodiode when impinging onto the photodiode facet 52 at the Brewster angle. The angle α between the axis of the ridge 53 and a line normal to the tilted photodiode facet 52 was 15.6°. The separation of laser and photodiode was relatively large (40 um on beam axis) and is not yet optimized. Shorter distances will result in an overall increase in measuring sensitivity.

## Claims

1. Integrated semiconductor structure comprising a laser diode (11) and at least one photodiode (12A, 12B; 51), with etched mirror- and photodiode- facets (21, 22; 52), respectively, and in which the photodiode is optically coupled with the laser diode so as to produce, when activated, a photocurrent in response to the impinging light beam emitted by the laser diode,
characterized in that
said photodiode (12A, 12B; 51) has a spatially non-uniform sensitivity profile with regard to the incident light beam (18A, 18B; 54) such that, with a beam of constant total power, the resulting photocurrent depends on the intensity distribution of the light impinging onto the photodiode.

2. An integrated structure as in claim 1, wherein said etched mirror-and photodiode-facets are vertical and arranged at a distance from each other that allows the measuring of the far-field intensity distribution of said emitted light beam.

3. An integrated structure as in claim 2, wherein the active layer (14) of said laser diode lies in the same plane as the pn-junction of said photodiode.

4. An integrated structure as in claim 3, wherein said photodiode facet (16A, 16B) has a non-linear profile such that the distance between said active layer (14), ending at the etched mirror facet (16A, 16B), and the pn-junction of the photodiode, ending at the photodiode facet (21, 22), varies with the angle at which the light is emitted.

5. An integrated structure as in any of the preceding claims, wherein said laser diode (11) is integrated and coupled with two of said photodiodes (12A, 12B), facing the front-end and the rear-end laser mirror facets, respectively.

6. An integrated structure as in claim 4 and 5, wherein the facets (16A, 16B) of said two photodiodes have a non-linear profile, the profiles of the two photodiodes being mutually inverse with respect to the distance between the active laser waveguide and the pn-junction of the photodiodes.

7. An integrated structure as in claim 4, wherein the two opposite facets of said photodiode (42, 47) have a non-linear profile, the two facets being mutually inverse.

8. An integrated structure as in claim 1 or 2, wherein said photodiode facet (52) has a linear profile which is tilted with respect to the propagation direction of the laser beam (54).

9. An integrated structure as in claim 8, wherein the tilt angle is equal to the so-called Brewster angle (εp) at which the portion of the incident transverse-mode polarized light (56) that is transmitted into the photodiode, reaches its maximum.

10. An integrated structure as in claim 9, wherein the photodiode (51) is provided with a waveguiding ridge (53) running above and parallel to the path taken by the polarized light (56) that is transmitted into the photodiode when the angle of incidence of the laser light equals the Brewster angle.

11. A method for on-wafer testing of the far-field beam characteristics of a plurality of semiconductor laser diodes,
comprising the steps of
- providing, on a semiconductor wafer, said plurality of laser diodes, each integrated with at least one photodiode that is optically coupled with the associated laser diode so as to produce, when activated, a photocurrent in response to an impinging light beam emitted by the laser diode, and that has a spatially non-uniform sensitivity profile with respect to said impinging light beam, and
- successively applying, before cleaving the wafer to part the integrated laser diode/photodiode structures formed thereon, operating voltages to said laser diodes, resulting in the emission of said impinging light beam, and activating said optically coupled photodiodes to convert the impinging light to a photocurrent providing a test signal having an amplitude that depends on the far-field intensity distribution of said impinging light beam.

12. A method as in claim 11, wherein said laser diodes are integrated and optically coupled with two photodiodes, receiving the front-end and the rear-end laser beams, respectively, and wherein the difference of the photocurrents of the two photodiodes is formed to provide a test signal that is independent of the total power of said impinging light beam.

## Patentansprüche

1. Integrierte Halbleiteranordnung bestehend aus einer Laserdiode (11) und wenigstens einer Photodiode (12A, 12B; 51) mit geätzten Spiegel- beziehungsweise Photodiodenfacetten (21, 22; 52) und in der die Photodiode optisch so mit der Laserdiode gekoppelt ist, um, wenn aktiviert, einen Photostrom in Erwiderung auf einen von der Laserdiode emittierten auftreffenden Lichtstrahl zu produzieren,
dadurch gekennzeichnet, daß
die Photodiode (12A, 12B; 51) ein räumlich ungleichmäßiges Empfindlichkeitsprofil in Bezug auf den auftreffenden Lichtstrahl solcher Art hat, daß, bei einem Strahl konstanter Gesamtleistung, der resultierende Photostrom von der Intensitätsverteilung des auf die Photodiode auftreffenden Lichts abhängt.

2. Eine integrierte Anordnung nach Anspruch 1, bei der die geätzten Spiegel- und Photodiodenfacetten senkrecht und in einem Abstand voneinender angeordnet sind, der die Messung der Weitfeld-Intensitätsverteilung des emittierenden Lichtstrahls ermöglicht.

3. Eine integrierte Anordnung nach Anspruch 2, bei der eine aktive Schicht (14) der Laserdiode auf der gleichen Ebene wie der pn-Übergang der Photodiode liegt.

4. Eine integrierte Anordnung nach Anspruch 3, bei der die Photodiodenfacette (16A, 16B) ein nichtlineares Profil der Art besitzt, daß sich der Abstand zwischen der aktiven Schicht (14), die an der geätzten Spiegelfacette (16A, 16B) endet, und dem pn-Übergang der Photodiode, die an der Photodiodenfacette (21, 22) endet, mit dem Winkel, unter dem das Licht emittiert wird, ändert.

5. Eine integrierte Anordnung wie in jedem der vorhergehenden Ansprüche, bei der die Laserdiode (11) mit zwei der Photodioden (12A, 12B) integriert und gekoppelt ist, die den Vorderseiten- beziehungsweise den Rückseitenlaserspiegelfacetten gegenüberstehen.

6. Eine integrierte Anordnung nach den Ansprüchen 4 und 5, bei der die Facetten (16, 16B) der zwei Photodioden ein nichtlineares Profil besitzen, wobei die Profile der zwei Photodioden in Bezug zu dem Abstand zwischen dem aktiven Laserwellenleiter und dem pn-Übergang der Photodioden wechselseitig invers sind.

7. Eine integrierte Anordnung nach Anspruch 4, bei der die zwei entgegengesetzten Facetten der Photodioden (42, 47) ein nichtlineares Profil haben und die zwei Facetten wechselseitig invers sind.

8. Eine integrierte Anordnung nach Anspruch 1 oder 2, bei der die Photodiodenfacette (52) ein lineares Profil besitzt, das in Bezug zu der Ausbreitungsrichtung des Laserstrahls (54) geneigt ist.

9. Eine integrierte Anordnung nach Anspruch 8, bei der der Neigungswinkel dem sogenannten Brewster-Winkel (εp) entspricht, bei dem der Anteil des anregenden im transversal-Mode polarisierten Lichtes (56), das in die Photodiode übertragen wird, sein Maximum erreicht.

10. Eine integrierte Anordnung nach Anspruch 9, bei der die Photodiode (51) mit einem wellenleitenden Steg (53) ausgerüstet ist, der oberhalb und parallel zu dem Pfad verläuft den das polarisierte Licht (56) nimmt, das in die Photodiode übertragen wird, wenn der Anregungswinkel des Laserlichts gleich dem Brewster-Winkel ist.

11. Eine Methode für das Testen der Fernfeld-Strahlkennlinien einer Vielzahl von Halbleiter-Laserdioden, auf dem Wafer,
bestehend aus den Schritten
- des Lieferns der Vielzahl Laserdioden auf einem Halbleiterwafer, wobei jede mit wenigstens einer Photodiode integriert ist, die optisch mit der zugehörigen Laserdiode gekoppelt ist um, wenn aktiviert, einen Photostrom in Erwiderung auf den einfallenden Lichtstrahl, der von der Laserdiode emittiert wurde, zu erzeugen und ein räumlich ungleichmäßiges Empfindlichkeitsprofil in Bezug auf den auftreffenden Lichtstrahl hat und
- des erfolgreichen Anlegens der Betriebsspannung an die Laserdioden vor dem Aufspalten des Wafers zur Einteilung der darauf ausgebildeten integrierten Laserdioden-/Photodioden-Anordnungen, das in der Emission des auftreffenden Lichtstrahles resultiert und die optisch gekoppelten Photodioden aktiviert, um das auftreffende Licht in einen Photostrom, der ein Testsignal mit einer Amplitude, die von der Weitfeld Intensitätsverteilung des eintreffenden Lichtstrahls abhängt, besitzt, zu konvertieren.

12. Eine Methode nach Anspruch 11, bei der die Laserdioden mit zwei Photodioden integriert und optisch gekoppelt sind, welche die vorder- beziehungsweise rückwärtigen Laserstrahlen empfangen und wobei die Differenz der Photoströme der zwei Photodioden gebildet wurde, um ein Testsignal zu liefern, das unabhängig von der Gesamtleistung des auftreffenden Lichtstrahls ist.

## Revendications

1. Structure intégrée semiconductrice comprenant une diode laser (11) et au moins une photodiode (12A, 12B; 51), avec des facettes (21, 22; 52) attaquées de miroir-et de photodiode-, respectivement, et dans laquelle la photodiode est couplée optiquement avec la diode laser de manière à produire, lorsqu'elle est activée, un courant photoconducteur en réponse à l'incidence d'un faisceau lumineux émis par la diode laser,
caractérisée en ce que
ladite photodiode (12A, 12B; 51) a un profil de sensibilité non uniforme dans l'espace par rapport au faisceau de lumière incidente (18A, 18B; 54) de manière que, avec un faisceau de puissance totale constante, le courant photoconducteur résultant dépende de la répartition de l'intensité de la lumière venant frapper la photodiode.

2. Structure intégrée selon la revendication 1, dans laquelle lesdites facettes attaquées de miroir-et de photodiode- sont verticales et placées à une distance l'une de l'autre qui permet la mesure de la répartition de l'intensité du champ lointain dudit faisceau de lumière émise.

3. Structure intégrée selon la revendication 2, dans laquelle la couche active (14) de ladite diode laser se trouve dans le même plan que la jonction pn de ladite photodiode.

4. Structure intégrée selon la revendication 3, dans laquelle ladite facette de la photodiode (16A, 16B) a un profil non linéaire tel que la distance entre ladite couche active (14), se terminant sur la facette de miroir attaquée (16A, 16B), et la jonction pn de la photodiode, se terminant sur la facette (21, 22) de la photodiode, varie avec l'angle selon lequel la lumière est émise.

5. Structure intégrée selon l'une quelconque des revendications précédentes, dans laquelle ladite diode laser (11) est intégrée et couplée avec deux desdites photodiodes (12A, 12B), en regard des facettes de miroir laser à l'extrémité frontale et à l'extrémité arrière, respectivement.

6. Structure intégrée selon la revendication 4 et la revendication 5, dans laquelle les facettes (16A, 16B) desdites deux photodiodes ont un profil non linéaire, les profils des deux photodiodes étant inverses l'un de l'autre par rapport à la distance entre le guide d'onde laser actif et la jonction pn des photodiodes.

7. Structure intégrée selon la revendication 4, dans laquelle les facettes opposées de ladite photodiode (42, 47) ont un profil non linéaire, les deux facettes étant inverses l'une de l'autre.

8. Structure intégrée selon la revendication 1 ou 2, dans laquelle la facette (52) de la photodiode a un profil non linéaire qui est incliné par rapport à la direction de propagation du faisceau laser (54).

9. Structure intégrée selon la revendication 8, dans laquelle l'angle d'inclinaison est égal à un angle appelé "angle de Brewster" (εp) pour lequel la partie de la lumière incidente (56) polarisée en mode transversal qui est transmise dans la photodiode atteint son maximum.

10. Structure intégrée selon la revendication 9, dans laquelle la photodiode (51) comporte un rebord (53) formant guide d'onde situé au-dessus et parallèlement au trajet emprunté par la lumière polarisée (56) qui est transmise dans la photodiode lorsque l'angle d'incidence de la lumière laser est égal à l'angle de Brewster.

11. Procédé pour l'essai sur plaquette des caractéristiques du faisceau à champ lointain de plusieurs diodes laser semiconductrices,
comprenant les étapes de
- réalisation, sur une plaquette semiconductrice, desdites plusieurs diodes laser, chacune intégrée avec au moins une photodiode qui est couplée optiquement avec la diode laser associée de manière à produire, lorsqu'elle est activée, un courant photoconducteur en réponse à un faisceau lumineux incident émis par la diode laser, et qui a un profil de sensibilité non uniforme dans l'espace par rapport audit faisceau lumineux incident, et
- d'application, successivement, avant la séparation de la plaquette afin de séparer les structures intégrées de diode laser/photodiode formées sur celle-ci, de tensions de fonctionnement audites diodes laser, conduisant à l'émission dudit faisceau lumineux incident, et d'activation desdites photodiodes couplées optiquement pour convertir la lumière incidente en un courant photoconducteur fournissant un signal d'essai ayant une amplitude qui dépend de la répartition de l'intensité du champ lointain dudit faisceau lumineux incident.

12. Procédé selon la revendication 11, dans lequel lesdites diodes laser sont intégrées et couplées optiquement avec deux photodiodes, recevant les faisceaux laser d'extrémité frontale et d'extrémité arrière, respectivement, et dans lequel la différence des courants photoconducteurs des deux photodiodes est formée pour obtenir un signal d'essai qui est indépendant de la puissance totale dudit faisceau lumineux incident.
